# EUROPEAN PATENT APPLICATION

(11) **EP 4 425 250 A1**
(43) Date of publication of application: **04.09.2024**
(21) Application number: 22887544.9
(22) Date of filing: 25.10.2022
(51) Int. Cl.: G02F 1/1516, G02F 1/13, H10K 71/00, H05K 3/02, H05K 3/00, H05K 1/09

(54) **METHOD FOR MANUFACTURING MULTILAYER THIN-FILM FPCB AND HEATER**

(30) Priority: 25.10.2021 KR 20210142502; 15.12.2021 KR 20210179433
(71) Applicant: Seoul National University R&DB Foundation, Seoul 08826 (KR)
(72) Inventor: KO, Seung Hwan, Seoul 08826 (KR); CHOI, Joon Hwa, Seoul 08826 (KR); KIM, Hyun Seok, Seoul 08826 (KR); KIM, Kwon Kyu, Seoul 08826 (KR)
(74) Representative: TRBL Intellectual Property
(86) International application number: PCT/KR2022/016321
(87) International publication number: WO 2023/075348

(57) **Abstract**

The present invention relates to a method for manufacturing a multilayer thin FPCB, and the method for manufacturing a multilayer thin FPCB according to the present invention relates to a method for manufacturing an FPCB (Flexible Printed Circuit Board) comprising coating metal nanoparticles on a first flexible substrate of a thin film; applying a laser to the metal nanoparticles to sinter the metal nanoparticles and pattern them; cleaning the metal nanoparticles unsintered; laminating a second flexible substrate of a thin film on the first flexible substrate in which a pattern is formed; forming a via hole on the second flexible substrate using a laser; coating metal nanoparticles on the second flexible substrate; applying a laser to the metal nanoparticles to sinter the metal nanoparticles and pattern them; and cleaning the metal nanoparticles unsintered.

## Description

### [TECHNICAL FIELD]

The present invention relates to a method for manufacturing a multilayer thin FPCB (Flexible Printed Circuit Board), and more specifically, it relates to a method for manufacturing a multilayer thin FPCB which forms a pattern on a thin film flexible substrate and forms a via hole on the thin film flexible substrate to connect patterns of each layer.

In addition, the present invention relates to a method for manufacturing a display comprising a multi-layered ultra-thin film heater, and a display and a device comprising the same.

### [BACKGROUND ART]

In recent years, with the trend of integration, miniaturization, thinning, densification, and high-angulation of electronic products, the need of a Printed Circuit Boards (PCB) which is easy to be equipped even in a narrower space has increased, and according to this market demand, miniaturization and densification are possible, and a Flexible Printed Circuit Board (FPCB) having repetitive flexibility was developed. As the use of such an FPCB is dramatically increasing due to technological advancement such as wearable devices, smartphones, rollable electronic devices, robots and the like, and the demand is further increasing.

Conventionally, in order to prepare the FPCB, it was prepared by a method such as metal deposition, light exposure using a mask, and etching and the like on an insulating base with high heat resistance and high flexibility, but the manufacturing process is complicated, so there are problems that it takes a lot of time and manufacturing costs are high.

In addition, conventionally, the process was conducted in a high temperature environment, there were disadvantages in that the substrate material was limited to a polyimide substrate and the like, and an FPCB could not be manufactured with a thin film with a several micro thickness.

On the other hand, in the recent information-oriented society, a display device is a visual information transmission medium, and its importance is being emphasized more than ever. The current mainstream Cathode Ray Tube or Braun tube has a problem of large weight and volume.

This flat display device comprises many thin film patterns, and each thin film pattern is formed by a photolithography process and an etching process.

In general, a metal layer is formed on a substrate for a flat display device by a deposition method such as sputtering. Subsequently, a photoresist pattern is formed by conducting a photolithography process including photoresist applying, light exposure and developing processes. By performing a dry or wet etching process using a mask for this photoresist pattern, a metal layer which is not overlapped with the photoresist pattern. After that, the photoresist pattern (5) is removed by a strip process to form a first thin film pattern.

In general, in case of a film-type heater in which a pattern is formed, as it is prepared with a thickness of an insulating layer and a metal layer of tens of micrometers or more, the heat capacity per unit area is high and the temperature change is less compared to the energy amount, so there is a limit to rapid temperature control.

### [DISCLOSURE]

### [TECHNICAL PROBLEM]

Accordingly, an object of the present invention is to solve such conventional problems, and is to provide a method for manufacturing a multilayer thin FPCB which can reduce production costs and manufacture a multilayer thin FPCB at a superhigh speed by a method for forming a pattern and a via hole using a visible/ultraviolet laser in an environment of room temperature, atmospheric pressure, and no masking.

In addition, the present invention has been contrived to solve the technical problem described above, and an object thereof is to provide a method for manufacturing a display comprising a multi-layered ultra-thin film heater capable of implementing high resolution images by reducing temperature changes even with low heat capacity, by enabling a multi-layered ultra-thin film heater in which a thermochromic resin that reacts to heat or infrared rays is coated to be expressed as an image using an overlapping pattern, and a display and a device comprising the same.

Furthermore, an object of the present invention is to provide a method for manufacturing a display comprising a multi-layered ultra-thin film heater which can minimize heat loss in a horizontal direction, by allowing a movement path of heat transfer by an ultra-thin film heater with a thickness of several micrometers comprising a plurality of pattern layers electrically connected in a vertical direction, and a display and a device comprising the same.

The problems to be solved by the present invention are not limited to the problems mentioned above, and other problems not mentioned will be clearly understood by those skilled in the art from the description below.

### [TECHNICAL SOLUTION]

The technology suggested in one example of the present invention relates to a method for manufacturing an FPCB (Flexible Printed Circuit Board), and can be achieved by a method for manufacturing a multilayer thin FPCB comprising coating metal nanoparticles on a first flexible substrate of a thin film; applying a laser to the metal nanoparticles to sinter the metal nanoparticles and pattern them; cleaning the metal nanoparticles unsintered; laminating a second flexible substrate of a thin film on the first flexible substrate in which a pattern is formed; forming a via hole on the second flexible substrate using a laser; coating metal nanoparticles on the second flexible substrate; applying a laser to the metal nanoparticles to sinter the metal nanoparticles and pattern them; and cleaning the metal nanoparticles unsintered.

In one example according to the present invention, the flexible substrate may be a polyimide substrate.

In one example according to the present invention, the metal nanoparticles may be any one of gold (Au), silver (Ag), copper (Cu), and aluminum (Al).

In one example according to the present invention, it is preferable that the laser forming the via hole is a UV laser.

In one example according to the present invention, modifying the pattern formed on the flexible substrate may be further comprised.

Herein, the modifying the pattern may comprise selectively erasing the pattern using a UV laser.

Herein, the modifying the pattern may further comprise coating metal nanoparticles on the flexible substrate; applying a laser to the metal nanoparticles to sinter the nanoparticles and pattern them; and cleaning the metal nanoparticles unsintered.

Herein, the metal nanoparticles may be coated on the flexible substrate by spin coating.

The technology suggested in another example of the present invention relates to a multilayer thin FPCB, and it comprises a plurality of laminated flexible substrates with a thickness of several tens of ,um or less, on which different patterns from each other are formed with metal nanoparticle sintered bodies, and comprises a via hole that commonly penetrates the plurality of laminated flexible substrates, and all the patterns and the via hole are formed by irradiating a laser.

In one example according to the present invention, the metal nanoparticles may comprise any one selected from the group consisting of gold, silver, copper and aluminum, and the patterns may be modified by using a laser, and the via hole may have a diameter of 10 ,um to 50 ,um.

In one example according to the present invention, the metal nanoparticle sintered bodies may comprise a polymer additive component to disperse the metal nanoparticles.

In one example according to the present invention, a non-uniform morphology of a bumpy surface with a size of several nm to tens of nm may be confirmed on the surface of the patterns.

In one example according to the present invention, a mound may be formed in the center of the via hole, and a non-smooth surface may be formed on the side wall of the via hole.

In addition, the method for manufacturing a display comprising a multi-layered ultra-thin film heater suggested in one other aspect of the present invention may comprise forming an ultra-thin film substrate by applying an insulating organic material solution on a substrate and coating and curing it; performing metal nanoparticle coating by irradiating laser light; performing metal nanowire first patterning using laser light; after the first patterning, forming a first electrical insulating layer by coating and curing an insulating organic material solution; forming at least one via hole (Vertical Interconnect access, VIA) that is a pathway on the substrate; performing metal nanoparticle coating and metal nanowire second patterning using laser light; and after the second patterning, forming a second electrical insulating layer by coating and curing an insulating organic material solution.

Herein, the metal nanoparticle coating may include a stencil and spray coating mixing method and inkjet printing.

Moreover, the metal nanoparticles and metal nanowire may preferably comprise a precious metal, for example, silver (Ag), gold (Au), platinum (Pt), and the like.

In one example according to the present invention, the insulating organic material may be performed by a spray method or spin coating method.

In one example according to the present invention, forming a signal input terminal by additional patterning of a metal nanowire after forming the second electrical insulating layer, and coating a thermochromic resin on a heating heater zone may be further comprised.

In one example according to the present invention, the via hole (Vertical Interconnect access, VIA) may be formed in a vertical direction to the ground.

In addition, the present invention provides a display comprising a multilayer comprising a multi-layered ultra-thin film heater, comprising a substrate prepared by applying and curing an insulating organic material on at least one side; and a plurality of pattern layers in which a metal nanowire is patterned on at least one side of the substrate and a vertical through hole is formed on at least a part of it, in which the pattern layers have a structure that they are electrically connected to each other through the through hole.

In one example according to the present invention, the ultra-thin film heater may be formed with a thickness of 0.1 ~ 100 micrometers.

In one example according to the present invention, a non-uniform morphology of a surface with a size of several nm to tens of nm may be confirmed on the surface of the pattern layers.

In one example according to the present invention, a mound may be formed in the center of the vertical through hole, and a non-smooth surface may be formed on the side wall of the via through hole.

On the other hand, the present invention provides a device comprising the display comprising a multi-layered ultra-thin film heater as above, and therefore, for example, it may be applied to applicable devices capable of visual image representation such as a wearable device, a flexible electronic device, a semiconductor device, a transparent electrode or a bio device, and the like.

### [ADVANTAGEOUS EFFECTS]

According to the method for manufacturing a multilayer thin FPCB of the present invention as described above, there is an advantage in that manufacturing costs can be reduced and an FPCB can be manufactured at a superhigh speed by an engineering method using a visible/ultraviolet laser in an environment of room temperature, atmospheric pressure and no masking.

In addition, there is also an advantage in that a multilayer thin FPCB with a thickness of tens of micros can be manufactured compared to the conventional.

Furthermore, there is also an advantage in that it can be manufactured using a substate made of an inexpensive material such as plastic, since there is no limit on a material of a flexible material as it is manufactured by a room temperature and atmospheric pressure process.

The method for manufacturing a display comprising a multi-layered ultra-thin film heater and a display and a device comprising the same according to the present invention, can provide an effect of reducing temperature changes even with low heat capacity to enable to implement an ultra-thin film heater with a laminated multilayer structure in which a thermochromic resin that reacts to heat or infrared rays is coated to high resolution images using an overlapping pattern.

In addition, the method for manufacturing a display comprising a multi-layered ultra-thin film heater and a display and a device comprising the same according to the present invention can provide an effect of minimizing heat loss in a horizontal direction, as the movement path of heat transfer can be adjusted to the shortest distance by an ultra-thin film heater with a thickness of several micrometers comprising a plurality of pattern layers with a structure electrically connected in a vertical direction.

### [BRIEF DESCRIPTION OF THE DRAWINGS]

FIG. 1 is a drawing showing the order of the method for manufacturing a multilayer thin FPCB according to one example of the present invention.
FIG. 2 is a drawing showing the order of the method for modifying a pattern on a flexible substrate on which a pattern is formed according to one example of the present invention.
FIG. 3 is a drawing showing a part of the method for manufacturing according to FIG. 1.
FIG. 4 is a drawing showing a process for modifying the pattern according to one example of the present invention.
FIG. 5 is a perspective view showing each layer of the multilayer thin FPCB manufactured according to the present invention separated.
FIG. 6 is an actual photograph of the multilayer thin FPCB manufactured according to the present invention.
FIG. 7 is drawings showing the process of manufacturing a display comprising an ultra-thin film substrate according to one example of the present invention.
FIG. 8 is a conceptual diagram showing the heat spreading phenomenon of the heater comprising an ultra-thin film substrate according to the present invention.
FIG. 9 is a conceptual diagram showing image representation by the heater comprising an ultra-thin film substrate according to the present invention.
FIG. 10 are image implement examples through the heater comprising an ultra-thin film substrate according to the present invention.
FIG. 11 are photographs showing an application example comprising a substrate according to the present invention.
FIG. 12 is a drawing exemplarily showing the laminated structure of the heater comprising a substrate according to the present invention.
FIG. 13 is a schematic diagram and micrographs showing the heater comprising a substrate according to the present invention.
FIG. 14 and FIG. 15 are images comparing and confirming the light spreading effect when using the heater comprising a substrate according to Comparative example (FIG. 14) and the example of the present invention (FIG. 15).
FIG. 16 to FIG. 18 are photographs which can confirm that a non-uniform morphology is confirmed on the surface of the nanoparticle sintered by a laser and a mound is formed at the center of the via hole, when a substrate or heater comprising the substrate according to the example of the present invention.

### [MODE FOR INVENTION]

Examples of the present invention are illustrated for the purpose of describing the technical spirit of the present invention. The scope according to the present invention is not limited to examples or detailed description for these examples presented below.

All technical terms and scientific terms used in the present invention, unless otherwise defined, have meanings commonly understood by those skilled in the art to which the present invention pertains. All terms used in the present invention are selected for the purpose to more clearly describe the present invention, and are not selected to limit the scope according to the present invention.

Expressions such as "comprising", "with", "having" and the like used in the present invention, unless otherwise stated in the phrase or sentence comprising the corresponding expression, should be understood as open-ended terms containing possibility to include other examples.

Expressions of the singular form described in the present invention may include a meaning of the plural form unless otherwise mentioned, and this is applied to expressions of the singular form described in the claims in the same manner.

Hereinafter, with reference to the accompanied drawings, the examples of the present invention will be described. In addition, in the description of the following examples, describing the same or corresponding elements repeatedly may be omitted. However, even if the description for the elements is omitted, it is not intended to be that such elements are not included in any example.

Specific details of examples are included in the detailed description and drawings.

Hereinafter, by the examples of the present invention, the present invention will be described with reference to the drawings for explaining the method for manufacturing a multilayer thin FPCB.

The present invention relates to a multilayer thin FPCB and a substrate-laminated heater prepared using a laser processing method, and the examples of the present invention will be described by focusing on two kinds of applications.

### 1. Technology for manufacturing a multilayer thin FPCB

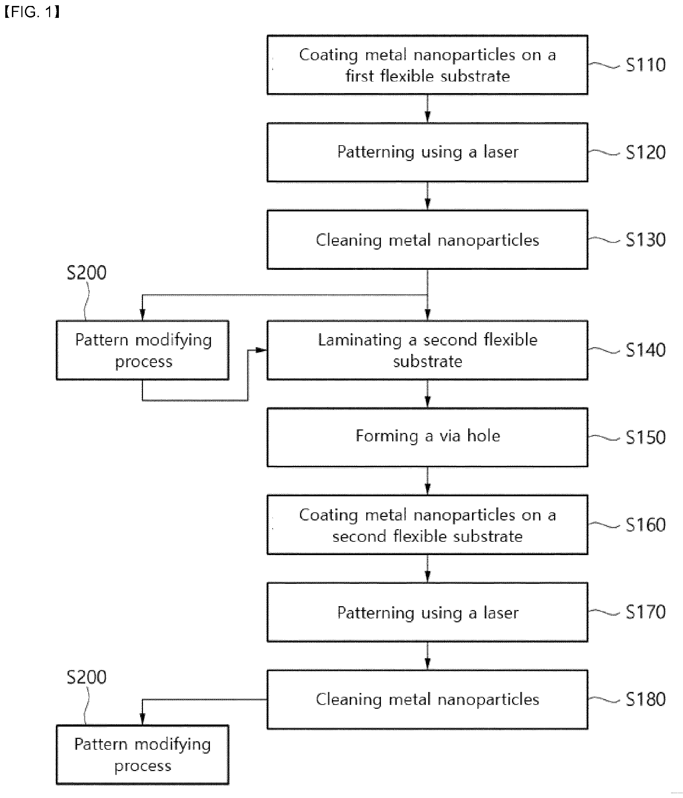

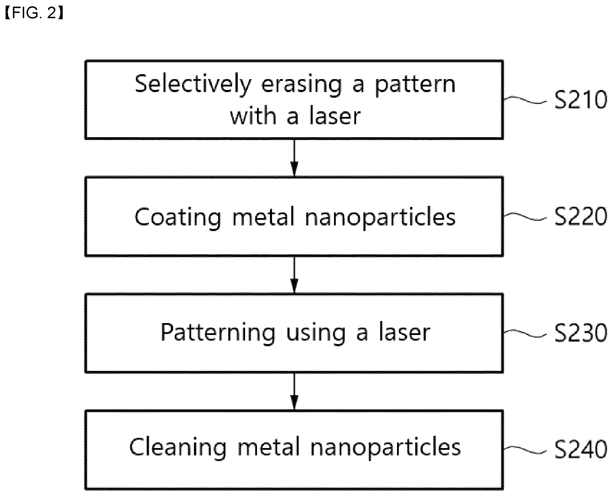

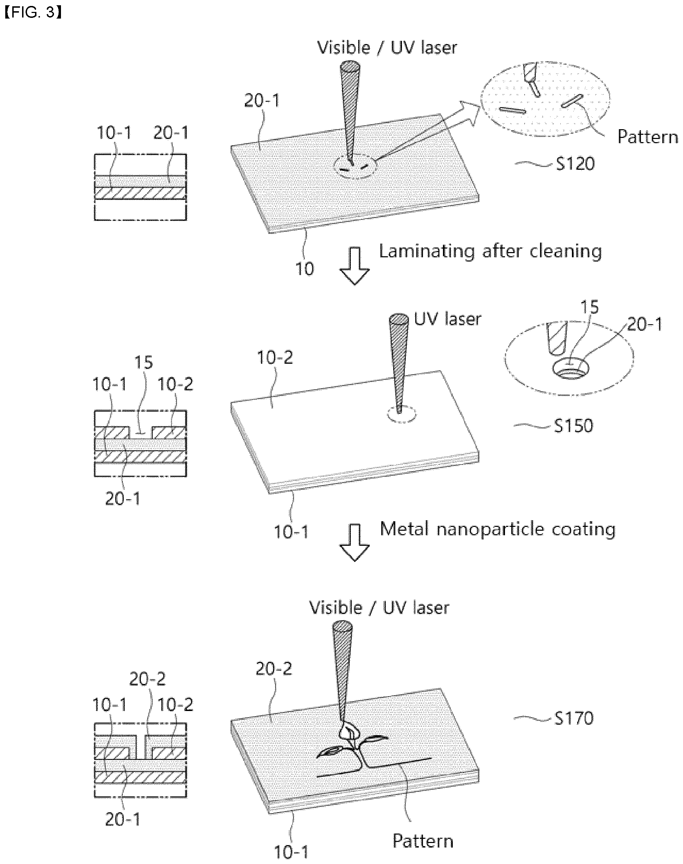

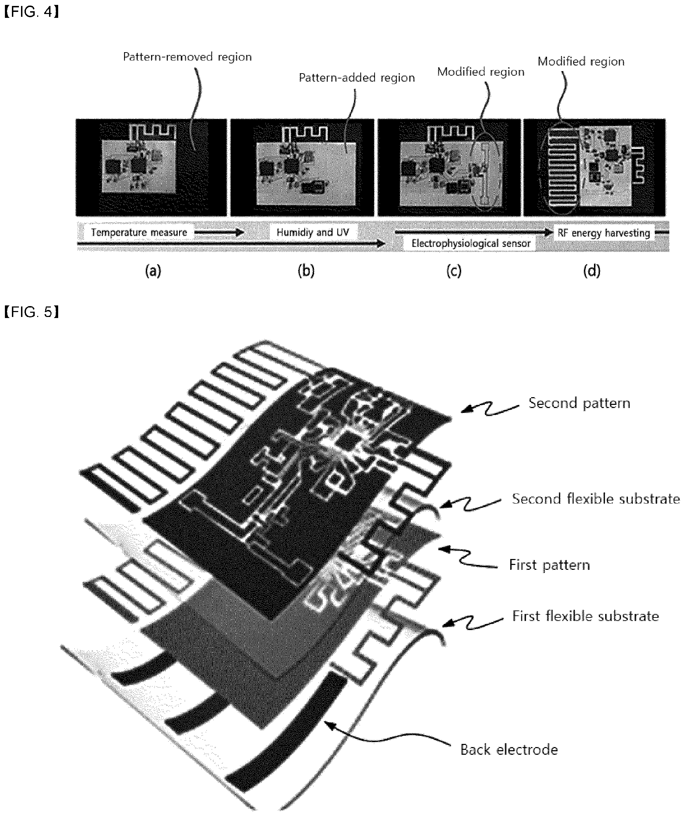

FIG. 1 is a drawing showing the order of the method for manufacturing a multilayer thin FPCB according to one example of the present invention, and FIG. 2 is a drawing showing the order of the method for modifying a pattern on a flexible substrate on which a pattern is formed according to one example of the present invention, and FIG. 3 is a drawing showing a part of the method for manufacturing according to FIG. 1, and FIG. 4 is a drawing showing a process for modifying the pattern according to one example of the present invention.

The method for manufacturing a multilayer thin FPCB according to one example of the present invention may comprise coating metal nanoparticles (20-1) on a first flexible substrate (10-1) of a thin film (S110); applying a laser to the metal nanoparticles (20-2) to sinter the metal nanoparticles (20-1) and pattern them (S120); cleaning the metal nanoparticles (20-1) unsintered (S130); laminating a second flexible substrate (10-2) of a thin film on the first flexible substrate (10-1) in which a pattern is formed (S140); forming a via hole (through hole) (15) on the second flexible substrate (10-2) using a laser (S150); coating metal nanoparticles (20-2) on the second flexible substrate (10-2) (S160); applying a laser to the metal nanoparticles (20-2) to sinter the metal nanoparticles (20-2) and pattern them (S170); and cleaning the metal nanoparticles (20-2) unsintered (S180).

At first, metal nanoparticle (20-1) may be coated on a first flexible substrate (10-1) of a thin film (S110).

The material of the flexible substrate (10) may be polyimide, but not limited thereto. In particular, the process for manufacturing a multilayer thin FPCB according to the present invention is conducted in a room temperature and an atmospheric pressure, so there is no need to consider modifications according to the temperature and pressure, and therefore, a flexible substrate (10) made of an inexpensive plastic material may be used.

In the present example, a flexible substrate made of polyimide may be produced by a method of spin coating polyimide dissolved in a solvent to obtain a thin film depending on a required thickness and curing it at a high temperature of about 300 degrees for a certain time.

At this time, in the present invention, a flexible substrate (10) having a thickness of several micrometers or less may be used.

A metal nanoparticle (20-1) layer is formed by applying metal nanoparticles (20-1) on the first flexible substrate (101) uniformly, but in the present example, the metal nanoparticle (20-1) is formed by a method of spin coating. For example, a layer in which nanoparticles are uniformly applied may be formed by a spin coating method for dropping a solution in which silver nanoparticles are mixed in ethanol on a flexible substrate (20) and rotating a stage in which the flexible substrate (20) is mounted.

In the present example, as the material of the metal nanoparticles (20), silver (Ag) is used, but not limited thereto, and in addition to silver, any one conductive substance of gold (Au), copper (Cu), and aluminum (Al) may be used.

Then, patterning may be performed by applying a laser to metal nanoparticles (20-1) to sinter the metal nanoparticles (20-1) (S120).

In the present example, a pattern is formed by applying laser light according to the pattern shape designed using a visible laser. Then, not only the visible laser but also a UV lase may be used. When a laser is applied, the metal nanoparticles (20) may be sintered and the metal nanoparticles (20) may be connected, and depending on the spot where a laser is applied on a flexible substrate (10), a pattern may be formed. In the present example, a pattern may be formed by scanning the entire surface of the flexible substrate (10) using a laser system of Galvano scanning method, and a pattern may be formed at a high speed of approximately 20mm2/s.

Then, the unsintered metal nanoparticles (20-1) may be clearly cleaned using a certain cleaning solution such as water or ethanol (S120). Therefore, by removing all the metal nanoparticles (20-1) in addition to the pattern sintered and bound on the flexible substrate (10-1), a first flexible substrate (10-1) in which a pattern is formed may be manufactured.

Next, a multilayer FPCB may be manufactured by laminating a second flexible substrate (10-2) on the first flexible substrate (10-1) in which a pattern is formed (S140). Also, the second flexible substrate (10-2) may be laminated on the first flexible substrate (10-2) on the first flexible substrate (10-2), by a method for spin coating polyimide dissolved in a solvent to obtain a thin film with a required thickness and curing it at a high temperature, as described above.

Even for the second flexible substrate (10-2), as same as the first flexible substrate (10-1), a flexible substrate of a thin film may be used.

Then, a via hole (15) may be formed on the second flexible substrate (10-2) using a laser (S150).

The via hole (15) is a hole conduct between each pattern formed in different layers from each other. In the present example, a method for manufacturing a two-layer FPCB is described, but a multilayer FPCB of three layers or more comprising a third flexible substrate may be manufactured using the technical spirit of the present example. At this time, the via hole may be drilled through a third flexible substrate and a second flexible substrate together, thereby electrically connecting a pattern of the third flexible substrate and a pattern of the second flexible substrate, or a pattern of the third flexible substrate and a pattern of the first flexible substrate.

The via hole (5) is preferably formed with a UV laser. In case of the flexible substrate, the absorption rate of light in the visible range is significantly reduced, and most of the irradiated light is transmitted. In particular, as in the present invention, when light in the visible range is irradiated to a transparent polyimide substrate, 80% or more of light is transmitted. Accordingly, it may be considered to irradiate stronger visible laser light to absorb energy to form a via hole on a flexible substrate on the substrate, but this is not preferable in terms of precision and energy efficiency of the via hole. Therefore, in the present invention, the substrate may absorb most of the energy in the ultraviolet range using a UV laser in the ultraviolet range, and by precise adjustment of the UV laser energy, the via hole may be precisely processed on the flexible substrate having a thickness of several micrometers or less.

When a UV laser is used, selectively, the flexible substrate (10) may be drilled well, and the drilling depth may be controlled very precisely by adjusting power, and thus, the via hole (15) may be formed only on the second flexible substrate (10-2) without affecting the first flexible substrate (10-1) and the pattern formed on the first flexible substrate (10-1).

After forming the via hole (15) on the second flexible substrate (10-2), patterning may be performed on the second flexible substrate (10-2), through coating metal nanoparticles (20-2) on the second flexible substrate (10-2) (S160), applying a laser on the coated metal nanoparticles (20-2) to sinter the metal nanoparticles (20-2) and pattern them (S170), and cleaning the unsintered metal nanoparticles (20-2) (S180).

Each step for performing patterning on the second flexible substrate (10-2) is same as each step for patterning on the first flexible substrate (10-1) afore-mentioned, so the detailed description for this will be omitted.

When the metal nanoparticles (20-2) are coated on the second flexible substrate (10-2) by a method of spin coating, as shown in FIG. 3, the metal nanoparticles (20-2) may flow into even the edge of the via hole (15) to electrically connect the pattern of the first flexible substrate (10-1) and the second flexible substrate (10-2).

Like this, in the present invention, a multilayer thin FPCB may be manufactured rapidly with inexpensive processing costs by a method of room temperature, atmospheric pressure, and no masking, by a method for sintering metal nanoparticles (20) using a laser to form a pattern, and a via hole (15) is formed on a flexible substrate (10) of a thin film using a UV laser.

Furthermore, according to the method for manufacturing a multilayer thin FPCB according to the present invention, after patterning on the flexible substrate (10), a pattern shape may be modified (S200). According to the conventional method, there is a problem that a pattern should be manufactured on a new substrate again because once a pattern is formed, it cannot be modified, but in the present invention, when there is a defect in the pattern formed in the flexible substrate (10), this can be modified. As shown in FIG. 1, after forming a pattern for each layer, a pattern modifying process may be performed. In other words, after forming a pattern on the first flexible substrate (10-1) (S130) or after forming a pattern on the second flexible substrate (10-2) (S180), each pattern may be modified (S200).

The process of modifying a pattern may comprise selectively erasing a pattern using a laser (S210). At this time, it is preferable to remove it using a UV laser even when a pattern is erased. When a UV laser is used, a laser is selectively applied only to a pattern, and thereby, only the pattern may be easily removed without damaging the flexible substrate (10).

In (a) of FIG. 4, a state in which the previous pattern is removed by applying a UV laser to a certain area is shown.

Next, through coating metal nanoparticles (20) on an area on a flexible substrate in which a pattern is removed (S220), applying a laser to the metal nanoparticles (20) to sinter the metal nanoparticles (20) and pattern them (S230), and cleaning the metal nanoparticles (20) unsintered (S240), the pattern modified again may be formed. Each step is same as the contents described above, so the detailed description for this will be omitted.

In (c) and (d) of FIG. 4, a state in which a certain pattern is added through the above step to each certain area is shown.

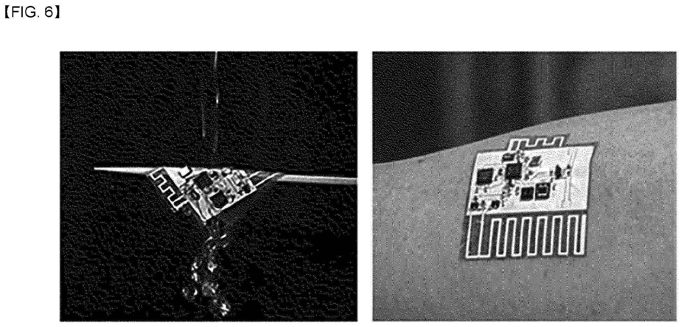

FIG. 5 is a perspective view showing each layer of the multilayer thin FPCB manufactured according to the present invention separated, and FIG. 6 is an actual photograph of the multilayer thin FPCB manufactured according to the present invention.

The technology suggested in another example of the present invention relates to a multilayer thin FPCB, and comprises a plurality of laminated flexible substrates with a thickness of tens of ,um or less, in which different patterns are formed from each other with metal nanoparticle sintered bodies, and comprises a via hole commonly penetrating the laminated plurality of flexible substrates, and all the patterns and the via hole are formed by irradiating a laser.

In one example according to the present invention, the metal nanoparticle may include any one selected from the group consisting of gold, silver, copper and aluminum, and the pattern may be modified using a laser, and the via hole may have a diameter of 10 µm to 50 µm.

In one example according to the present invention, the metal nanoparticle sintered bodies may comprise a polymer additive component for dispersing metal nanoparticles.

In one example according to the present invention, on the surface of the pattern, non-uniform morphology of a bumpy surface with a size of several nm to tens of nm may be confirmed.

In one example according to the present invention, a mound may be formed in the center of the via hole, and a bumpy surface may be formed in the side wall of the via hole.

The part where a mound can be formed in the center of the morphology and via hole, will be described in more detail in the description part of the heater in which processing is performed by the same method.

As shown in FIG. 5, a predetermined rear electrode may be disposed on the lower surface of the first flexible substrate (10-1), and a certain pattern may be formed on the upper surface by sintering the metal nanoparticles (20-1) using a laser by the afore-mentioned method. In addition, a second flexible substrate (10-2) may be laminated on the first flexible substrate (10-1) in which the pattern is formed, and a certain pattern may be formed on the second flexible substrate (10-2) by the same method. Before forming a pattern on the second flexible substrate (10-2), by drilling a via hole (15) using a UV laser, the pattern of the second flexible substrate (10-2) and the pattern of the first flexible substrate (10-1) may be electrically connected.

In FIG. 6, a state in which a commercial chip is combined to the FPCB manufactured as above is shown. The commercial chip may combine the chip and FPCB by lead patterning through stencil masking.

As shown in FIG. 6, it can be confirmed that the FPCB manufactured according to the present invention can manufacture a thin FPCB that bends flexibly according to the shape of the bottom surface and is folded by water pressure falling from above in multiple layers.

### 2. Technology for manufacturing a multi-layered ultra-thin film heater

On the other hand, the present invention relates to a method for manufacturing a display comprising a multi-layered ultra-thin film heater and a display and a device comprising the same, and provides a structure capable of image representation in a desired wavelength range such as infrared, visible, ultraviolet regions and the like by coating a thermochromic resin that reacts to heat or infrared rays or the like on the ultra-thin film heater in which multilayer pattern layers are laminated.

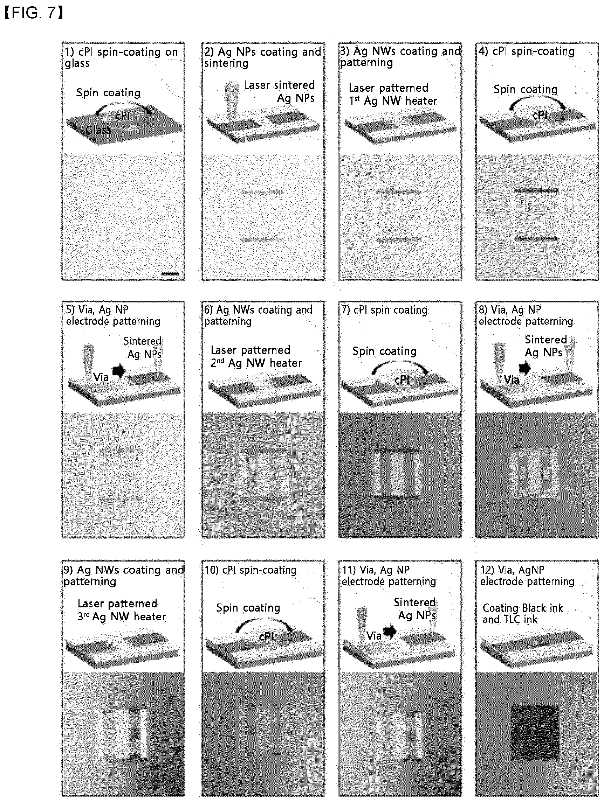

FIG. 7 shows drawings showing the process of manufacturing a display comprising an ultra-thin film substrate according to one example of the present invention.

When explained by referring to FIG. 7, the method for manufacturing a display comprising a multi-layered ultra-thin film heater according to the present invention, may comprise (a) forming an ultra-thin film substrate by applying an insulating organic material solution on a substrate and coating and curing, (b) performing silver nanoparticle (AgNP) coating by irradiating laser light, (c) performing the silver nanowire (AgNW) first patterning using laser light, (d) after the first patterning, forming a first electrical insulating layer by coating and curing an insulating organic material solution, (e) forming at least one via hole (Vertical Interconnect access, VIA) which is a passage on the substrate using a ultraviolet pulse laser, (f) coating silver nanoparticles (AgNPs) using laser light and performing the silver nanowire (AgNW) second patterning, and (g) after the patterning, forming a second electrical insulating layer by coating an insulating organic material solution and curing it.

Herein, according to the present invention, the pattern layer by the patterning may be formed into at least two layers or more depending on the conditions. In other words, for the pattern layer, a desired number of pattern layers may be formed into a shape in which a plurality of pattern layers are laminated by repeatedly performing the step (d) to step (g).

Specifically, at first, the step (a) of forming an ultra-thin film substrate by applying an insulating organic material solution, for example, transparent polyimide (Clear Polyimide: CPI) on a substrate and coating and curing may be performed. At this time, according to the present invention, the substrate may preferably comprise for example, glass, plastic, silicone or a synthetic resin and a metal, as a material having a certain flexibility. In some cases, it may comprise a substrate made of an organic thin film or transparent polymer, but not limited thereto, and for example, the substrate may comprise at least one of polyimide, polyethyleneterephthalate, polycarbonate and Poly(methyl methacrylate) (PMMA).

A thermochromic liquid crystal may be used as a thermochromic organic material, and for example, it may comprise a display in which various materials of which optical properties change depending on temperature are coated.

In addition, the insulating organic material solution is not particularly limited as long as it is a paint that can be converted into heat which reacts to heat or infrared rays, and may comprise a known photosensitive material which can be effectively converted by the heat or light energy. Preferably, it may be performed by a method for applying the insulating organic material on the substrate by a spin coating method or a spray method, but it is surely not limited thereto.

Next, the step (b) performing silver nanoparticle (AgNP) coating by irradiating a laser on the substrate and (c) performing silver nanowire (AgNW) first patterning using a laser may be performed.

An electrode may be formed by performing silver nanowire (AgNW) first patterning after coating silver nanoparticles (AgNPs) using light energy such as a laser and the like on the substrate in which the afore-mentioned insulating organic material is spin coated. At this time, the amount of heat generation may be low when voltage is applied to a high-conductive region by the silver nanoparticle coating.

Then, the silver nanoparticles may be substituted with other metal nanoparticles. The metal nanoparticles may be coated in a state prepared as a solution for coating, and the metal nanoparticles may be mixed with a polymer additive for homogeneous dispersion - for example, a PVP (Polyvinylpyrrolidone) component.

Therefore, subsequently, an electrode may be formed by performing the first patterning with a silver nanowire (AgNW) after coating silver nanoparticles (AgNP) using light energy such as a laser or stencil on the substrate. At this time, the first patterning may be a low-conductive region, which is a region where heat is generated when voltage is applied.

After that, the process (d) of forming an electrode comprising a first electrical insulating layer by coating the insulating organic material solution and coating and curing after the first patterning is performed. Herein, in the ultra-thin film heater with a multilayer laminated structure according to the present invention, the process (e) of forming a via hole (Vertical Interconnect access, VIA) which can be provided as a passage on the substrate is performed.

Subsequently, the step (f) of coating silver nanoparticles (AgNPs) using laser light and performing silver nanowire (AgNW) second patterning is performed. In the same manner, in some cases, a process of forming a via hole (Vertical Interconnect access, VIA) which can be provided as a passage on the substrate using an ultraviolet pulse laser also in the additional pattern layer by the second patterning. As the method for forming this via hole, it may be the ultraviolet pulse laser, but not limited thereto, and for example, it may include pulse lasers in different wavelength ranges, micro drills, reactive ion etching (RIE) and the like.

In other words, a pattern layer is formed by the first patterning and an additional pattern layer is additionally formed by performing the second patterning by the same method. Then, in the pattern layer by the first patterning and the additional pattern layer by the second patterning, by the silver nanoparticle (AgNP) coating, through the via hole (Vertical Interconnect access, VIA), an electrode may be electrically connected.

Next, after the second patterning, forming a second electrical insulating layer by coating and curing an insulating organic material solution (g) may be performed. If an additional plurality of pattern layers (n) are to be formed, an electrode may be formed by performing the step (d) to step (f) repeatedly.

Finally, after forming the second electrical insulating layer, a display comprising a multi-layered ultra-thin film heater may be manufactured by patterning a silver nanowire (AgNW) to form a signal input terminal, and coating a thermochromic resin on a heating heater.

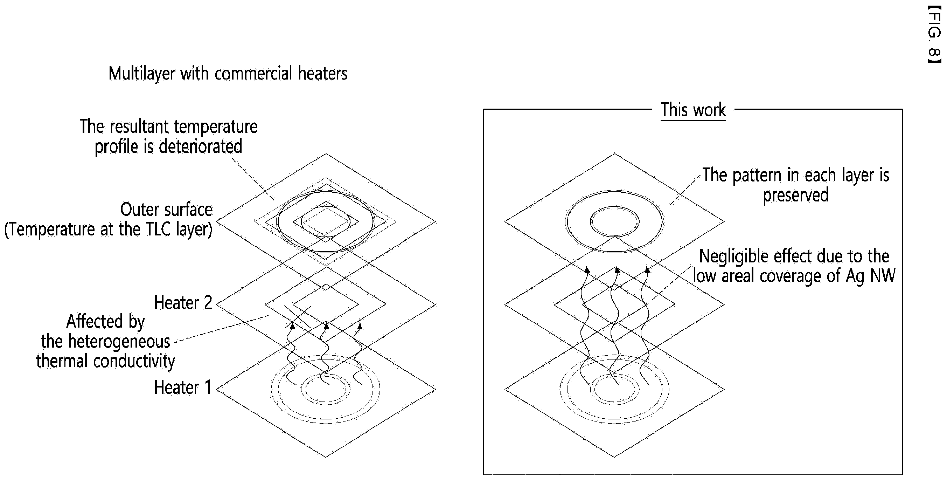

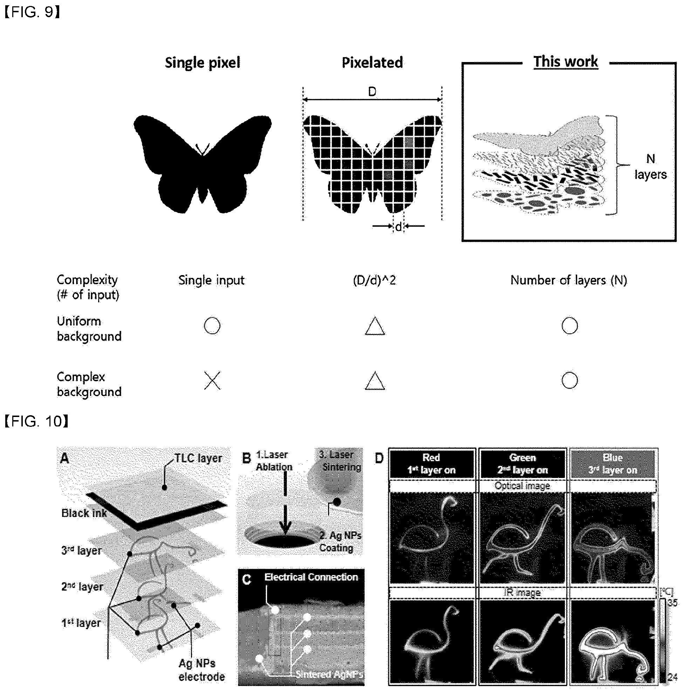

On the other hand, FIG. 8 is a conceptual diagram showing the heat spreading phenomenon of the heater comprising an ultra-thin film substrate according to the present invention, and FIG. 9 is a conceptual diagram showing image representation by the heater comprising an ultra-thin film substrate according to the present invention, and FIG. 10 are image implement examples through the heater comprising an ultra-thin film substrate according to the present invention.

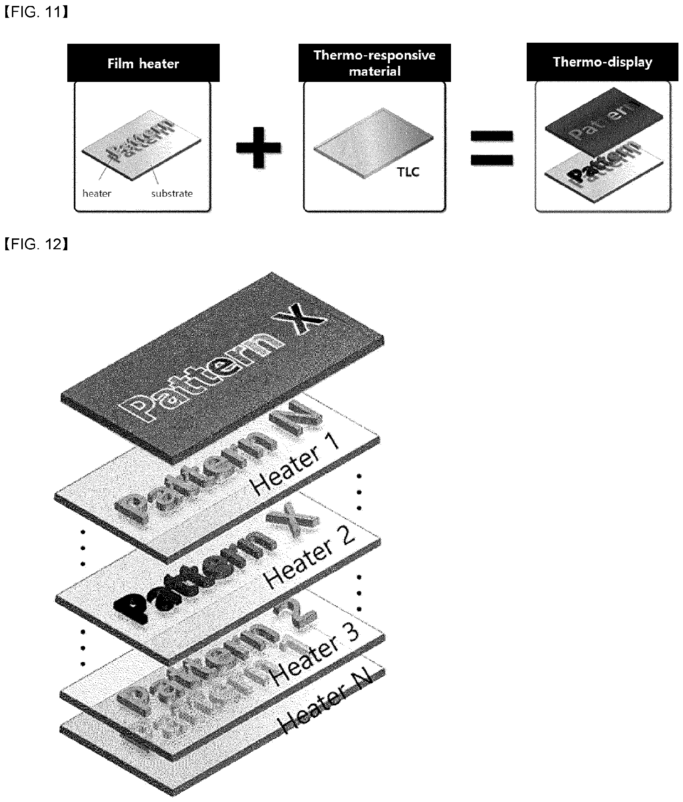

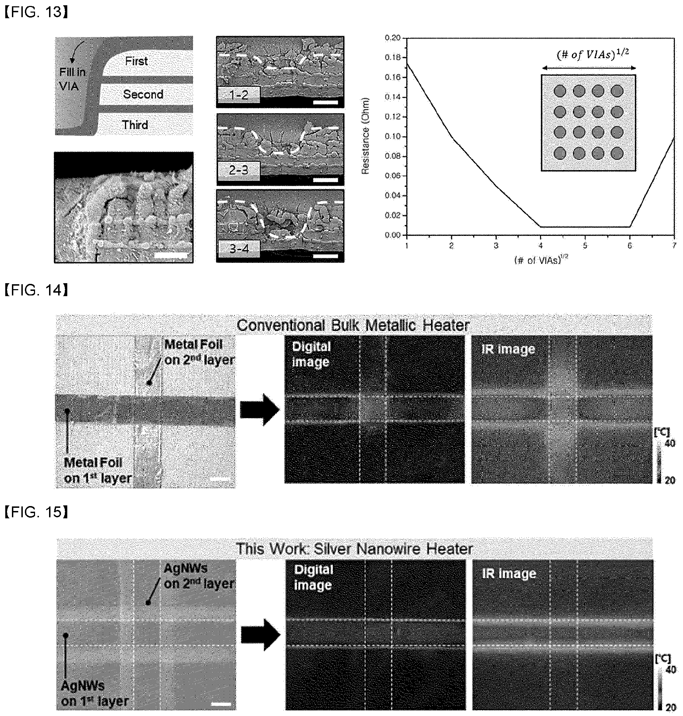

FIG. 11 are photographs showing an application example comprising a substrate according to the present invention, and FIG. 12 is a drawing exemplarily showing the laminated structure of the heater comprising a substrate according to the present invention, and FIG. 13 is a schematic diagram and micrographs showing the heater comprising a substrate according to the present invention.

FIG. 14 and FIG. 15 are images comparing and confirming the light spreading effect when using the heater comprising a substrate according to Comparative example (FIG. 14) and the example of the present invention (FIG. 15).

Referring to these drawings, the multi-layered ultra-thin film heater according to the present invention manufactured by the afore-mentioned method is composed of a structure of a plurality of layers laminated vertically, and is manufactured by coating a thermochromic liquid crystal solution which reacts to heat or infrared rays to discolor optical properties and curing it, and therefore, the heat or infrared rays are instantly transferred in a relatively very short distance in the vertical direction in the heater, thereby dramatically reducing a phenomenon in which a heat image is distorted. In other words, the multi-layered ultra-thin film heater according to the present invention may prevent a heat spreading phenomenon as heat diffusion is transferred in the vertical direction, not in the horizontal direction, compared to the conventional structure such as a film-type heater.

In addition, the multi-layered ultra-thin film heater as above can implement various and complicated patterns, as it is composed for a plurality of pattern layers to be vertically electrically connected through the via hole (Vertical Interconnect access, VIA). In other words, the multi-layered ultra-thin film heater according to the present invention may prevent the afore-mentioned heat spreading phenomenon by heat transfer in the vertical direction, compared to the conventional heater with a single layer structure. Moreover, in the multi-layered ultra-thin film heater according to the present invention, the number of control parameters is proportional to area, so in image representation through a grid of pixels, control variables are possible only as many as the number of patterns. Therefore, in the multi-layered ultra-thin film heater according to the present invention, compared to the conventional, control is possible using only a low-cost electronic circuit, and soft image representation depending on the shape of the heater is possible, thereby enabling high resolution image representation.

The ultra-thin heater manufactured by the method for manufacturing according to the present invention may be preferable to be formed with a thickness of 0.1 ~ 100 micrometers. In other words, when the thickness of the ultra-thin film heater is within the above range, the range is most preferable as heat transfer in the heater may be possible quickly in the vertical direction.

The display comprising a multi-layered ultra-thin film heater provided in other one example of the present invention comprises a substrate manufactured by applying and curing an insulating organic material on at least one side; and a plurality of pattern layers in which a metal nanowire is patterned on at least one side of the substrate and a vertical through hole is formed on at least some of it, and the pattern layer comprises a structure connected to each other through the through hole.

The display may be manufactured by the method for manufacturing suggested in one example of the present invention.

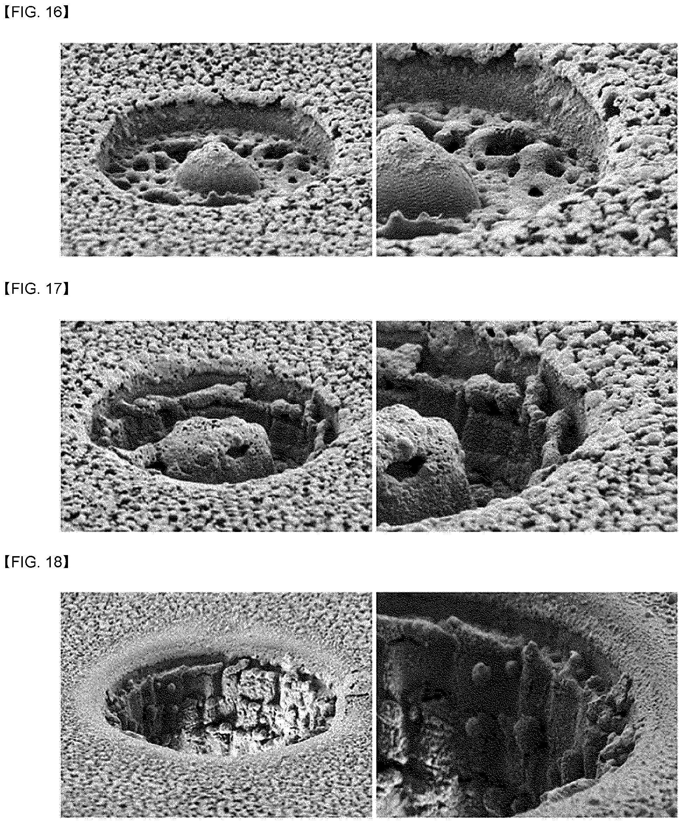

FIG. 16 to FIG. 18 are photographs which can confirm that a non-uniform morphology is confirmed on the surface of the nanoparticle sintered by a laser and a mound is formed at the center oof the via hole, when a substrate or heater comprising the substrate according to the example of the present invention.

FIG. 16 is a via in which only one layer is drilled, and FIG. 17 is a via in which two layers are drilled, and the bottom image of FIG. 18 is a micrograph of a via in which three layers are drilled.

As can be confirmed in FIG. 16 to FIG. 18, it can be confirmed that non-uniform morphology of a surface with a size of several nm to tens of nm is formed on the surface of the pattern layer.

The non-uniform morphology may have a structure in which bumpy protrusions at a level of several nm to tens of nm are formed on the morphology.

The non-uniform morphology may be formed at various degrees depending on the amount of the polymer additive - for example, PVP (Polyvinylpyrrolidone) - mixed for dispersion of metal nanoparticles.

As shown in FIG. 16 to FIG. 18, holes such as bubbles may be formed on the morphology, and this may occur as the polymer additive component evaporates when a laser is irradiated.

In addition, a mound may be formed at the center of the vertical through hole, and on the side wall of the vertical through hole, a bumpy surface may be formed. This is a phenomenon occurring when a laser is repeatedly moved along the circumference of a via in a circle and is processed, and the diameter of the via may be formed at a level of 10 ,um to 50 µm.

The ultra-thin film heater according to the present invention manufactured as above may be applied to a wearable device, a flexible electronic device, or a bio device. For example, the heater comprising the plurality of the laminated structures may be utilized in fields requiring visual representation such as a next-generation display, a camouflage military uniform, clothing, an automobile, a building, a robot exterior, artificial skin and the like.

The scope of the present invention is not limited to the afore-mentioned examples, but can be implemented as various types of examples in the attached claims. It is considered to be within the scope of the claims of the present invention to various ranges that anyone skilled in the art can modify without departing from the gist of the present invention as claimed in the claims.

The above description is illustratively describing the technical spirit of the present invention only, and those skilled in the art to which the present invention belongs can make various modification and variation in a range without departing from essential characteristics of the present invention. Therefore, the examples disclosed in the present invention are not intended to limit the technical spirit of the present invention, but are intended to describe it, and the scope of the technical spirit of the present invention is not limited. The scope of the present invention should be construed according to the claims below, and all the technical spirits within the equivalent range thereto should be construed as being included in the scope of the present invention.

### <DESCRIPTION OF THE SYMBOLS>

10-1: First flexible substrate
10-2: Second flexible substrate
15: Via hole
20: Metal nanoparticles

## Claims

1. A method for manufacturing a multilayer thin FPCB,
which relates to method for manufacturing an FPCB (Flexible Printed Circuit Board), and
comprises coating metal nanoparticles on a first flexible substrate of a thin film;
applying a laser to the metal nanoparticles to sinter the metal nanoparticles and pattern them;
cleaning the metal nanoparticles unsintered;
laminating a second flexible substrate of a thin film on the first flexible substrate in which a pattern is formed;
forming a via hole on the second flexible substrate using a laser;
coating metal nanoparticles on the second flexible substrate;
applying a laser to the metal nanoparticles to sinter the metal nanoparticles and pattern them; and
cleaning the metal nanoparticles unsintered.

2. The method for manufacturing a multilayer thin FPCB according to claim 1,
wherein the flexible substrate is a polyimide substrate.

3. The method for manufacturing a multilayer thin FPCB according to claim 1,
wherein the metal nanoparticles are any one of gold (Au), silver (Ag), copper (Cu), and aluminum (Al).

4. The method for manufacturing a multilayer thin FPCB according to claim 1,
wherein the laser forming the via hole is a UV laser.

5. The method for manufacturing a multilayer thin FPCB according to claim 1,
further comprising modifying the pattern formed on the flexible substrate.

6. The method for manufacturing a multilayer thin FPCB according to claim 5,
wherein the modifying the pattern
comprises selectively erasing the pattern using a UV laser.

7. The method for manufacturing a multilayer thin FPCB according to claim 6,
wherein the modifying the pattern
further comprises coating metal nanoparticles on the flexible substrate;
applying a laser to the metal nanoparticles to sinter the nanoparticles and pattern them; and
cleaning the metal nanoparticles unsintered.

8. A multilayer thin FPCB,
comprising a plurality of laminated flexible substrates with a thickness of several tens of ,um or less, on which different patterns from each other are formed with metal nanoparticle sintered bodies, and
comprising a via hole that commonly penetrates the plurality of laminated flexible substrates,
wherein all the patterns and the via hole are formed by irradiating a laser.

9. The multilayer thin FPCB according to claim 8,
wherein the metal nanoparticles comprise any one selected from the group consisting of gold, silver, copper and aluminum, and
the patterns can be modified using a laser, and
the via hole has a diameter of 10 ,um to 50 ,um.

10. The multilayer thin FPCB according to claim 8,
wherein the metal nanoparticle sintered bodies comprise a polymer additive component to disperse metal nanoparticles.

11. The multilayer thin FPCB according to claim 8,
wherein a non-uniform morphology of a bumpy surface with a size of several nm to tens of nm is confirmed on the surface of the patterns.

12. The multilayer thin FPCB according to claim 8,
wherein a mound is formed in the center of the via hole, and
a non-smooth surface is formed on the side wall of the via hole.

13. A method for manufacturing a display comprising a multi-layered ultra-thin film heater, comprising
forming an ultra-thin film substrate by applying an insulating organic material solution on a substrate and coating and curing it;
performing metal nanoparticle coating by irradiating laser light;
performing metal nanowire first patterning using laser light;
after the first patterning, forming a first electrical insulating layer by coating and curing an insulating organic material solution;
forming at least one via hole (Vertical Interconnect access, VIA) that is a pathway on the substrate;
performing metal nanoparticle coating and metal nanowire second patterning using laser light; and
after the second patterning, forming a second electrical insulating layer by coating and curing an insulating organic material solution.

14. The method for manufacturing a display comprising a multi-layered ultra-thin film heater according to claim 13,
wherein the insulating organic material is performed by a spray method or spin coating method.

15. The method for manufacturing a display comprising a multi-layered ultra-thin film heater according to claim 13,
further comprising forming a signal input terminal by additional patterning of a metal nanowire after forming the second electrical insulating layer, and
coating a thermochromic resin on a heating heater zone.

16. The method for manufacturing a display comprising a multi-layered ultra-thin film heater according to claim 13,
wherein the via hole (Vertical Interconnect access, VIA) is formed in a vertical direction to the ground.

17. A display comprising a multilayer comprising a multi-layered ultra-thin film heater, comprising
a substrate prepared by applying and curing an insulating organic material on at least one side; and
a plurality of pattern layers in which a metal nanowire is patterned on at least one side of the substrate and a vertical through hole is formed on at least a part of it,
wherein the pattern layers have a structure that they are electrically connected to each other through the through hole.

18. The display comprising a multilayer comprising a multi-layered ultra-thin film heater according to claim 17,
wherein a non-uniform morphology of a surface with a size of several nm to tens of nm is confirmed on the surface of the pattern layers.

19. The display comprising a multilayer comprising a multi-layered ultra-thin film heater according to claim 17,
wherein a mound is formed in the center of the vertical through hole, and
a non-smooth surface is formed on the side wall of the via through hole.

20. A device selected from a wearable device, a flexible electronic device, or a bio-device comprising the display according to claim 17.
